(19) Europäisches Patentamt
European Patent Office
Office européen des brevets

(11) EP 2 156 247 B1

(12) EUROPEAN PATENT SPECIFICATION

(45) Date of publication and mention of the grant of the patent:
**03.11.2010 Bulletin 2010/44**

(21) Application number: **08759973.4**

(22) Date of filing: **23.05.2008**

(51) Int Cl.:
***G03F 7/36*** *(2006.01)* ***G03F 7/38*** *(2006.01)*

(86) International application number:
**PCT/EP2008/056373**

(87) International publication number:
**WO 2008/151915 (18.12.2008 Gazette 2008/51)**

# (54) PROCESS FOR PREPARING A POLYMERIC RELIEF STRUCTURE

PROZESS ZUR HERSTELLUNG EINER POLYMERISCHEN RELIEF STRUKTUR

PROCÉDÉ DE PRÉPARATION D'UNE STRUCTURE EN RELIEF POLYMÈRE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **11.06.2007 EP 07109998**

(43) Date of publication of application:
**24.02.2010 Bulletin 2010/08**

(73) Proprietor: **Stichting Dutch Polymer Institute**
**5612 AB Eindhoven (NL)**

(72) Inventors:
- **PERELAER, Jolke**
**NL-5612 AZ Eindhoven (NL)**
- **HERMANS, Ko**
**NL-5600 MD Eindhoven (NL)**
- **BASTIAANSEN, Cornelis Wilhelmus Maria**
**NL-5600 MD Eindhoven (NL)**
- **SCHUBERT, Ulrich Sigmar**
**NL-5612 AZ Eindhoven (NL)**

(74) Representative: **Renkema, Jaap**
**IPecunia Patents B.V.**
**P.O. Box 593**
**6160 AN Geleen (NL)**

(56) References cited:
**WO-A-2005/008321 WO-A-2005/081071**
**WO-A-2006/085741 US-A1- 2005 032 997**

- **DATABASE WPI Week 199844 Thomson Scientific, London, GB; AN 1998-516313 XP002457741 & JP 10 228108 A (HITACHI CHEM CO LTD) 25 August 1998 (1998-08-25)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 156 247 B1

## Description

The present invention relates to a process for the preparation of a polymeric relief structure by

a) coating a substrate with a coating comprising one or more radiation-sensitive ingredients,
b) locally treating the coated substrate with electromagnetic radiation having a periodic or random radiation-intensity pattern, forming a latent image,
c) polymerizing and/or crosslinking the resulting coated substrate.

Such a process, hereinafter also to be called "photo-embossing is known from "photo-embossing as a tool for complex surface relief structures" De Witz, Christiane; Broer, Dirk J., Abstracts of Papers, 226th ACS National Meeting, New York, NY, United States, September 7-11, 2003.

Polymers with a surface relief structure have a wide range of applications. For instance, such polymers used in optical systems for data transport, storage and displays are nowadays of great interest. By structuring the surface of a polymer film or layer, light that passes these layers can be controlled. For instance if the surface structure contains small semi-sphere like elements a lens array is obtained that may focus transmitting light. Such an element is for instance useful in a backlight of a liquid crystal display to focus light on the transparent area of the display. For these types of applications it is often necessary to control the shape of the surface profiles down to the micrometer region. Also regular patterns of surface structures may diffract light such that a single beam, upon transmission, is split up in multiple beams that for instance can be used as beam splitter in telecommunication devices. Surface structures are also important to control reflection of light. This can successfully be applied to suppress specular reflection of a surface. This so-called anti-glare effect is for instance applied on the front screen of a television set. But also be used for applications such glazing, car finishes, etc. A polymer film, with well-defined surface profiles, may be provided with a conformal reflective film such as evaporated aluminum or sputtered silver. Incident light falling on this mirror is, upon reflection, distributed in space in a very controlled way. This is for instance used to make internal diffusive reflectors for reflective liquid crystal displays. Another application of surface profiles is for creating anti-fouling structures known as the Lotus effect. Thereto surface profiles with dimensions smaller than 1 micrometer are needed.

Electromagnetic-radiation induced polymerization, like UV photo-polymerization is a method to prepare devices from e.g. a mixture of two (meth)acrylate monomers and a photo-initiator. The polymerization reaction is initiated only in those regions where the UV light can activate the photo-initiator. In addition, it is possible to vary the light intensity spatially and vary the polymerization speed accordingly. Differences in the monomer reactivity, size or length, cross-linking ability, and energetic interaction result in gradients in the monomer chemical potentials. These chemical potentials form the driving force for monomer migration and for polymer swelling in the illuminated regions. The monomer diffusion coefficients determine the time-scale on which this migration takes place. Subsequently, uniform UV illumination with a higher intensity than during the patterned UV illumination is used to polymerize the entire film.

In specific cases, patterned UV photo-polymerization of a mixture of two liquid monomers results in a polymer relief structure. This can be done for example holographically or lithographically. Other methods to induce polymerization in a patterned way are based on writing with beams of electrons or ions. For holography, the interference pattern of two coherent light beams generates regions of high and low light intensity. For lithography, a photo-mask is used to produce these intensity differences. If for instance a striped mask is used, a grating is produced. If a mask with circular holes is used, a microlens structure is formed. Besides by creating a surface profile by material transport also refractive indices can be modulated. Differences in the refractive index are caused by lateral variations of monomer-unit concentrations in the polymer. Refractive index profile may further support the lens functions obtained from the surface geometries.

By using these techniques, it is possible to create phase and relief structures. It is also possible to design systems where the monomer migrates to the illuminated areas or away from it. Two mechanisms that describe the formation of the grating can be distinguished. Firstly, overall mass transport may occur, in which both monomers diffuse towards the illuminated regions. This is achieved by swelling of the growing polymer in the illuminated regions due to suction of monomers from the dark regions. This mechanism describes the formation of a relief grating. Secondly, if no swelling occurs, two-way diffusion, induced by differences in reactivity, describes the formation of a film with a flat surface, but a variation monomer unit concentration in the exposed and non-exposed areas. This mechanism describes the formation of a phase grating.

A better method to create surface structures is to use a blend that basically consists of a polymer, a monomer and an initiator. The polymer can be a single polymeric material but may also be a blend of more than one polymer. Similarly the monomer may be a single compound, but may also comprise several monomeric components. The initiator preferably is a photoinitiator that generates radicals upon exposure to UV-light. Alternatively, the photo-initiator generates cations upon exposure to UV light. The initiator may also be a mixture of a photoinitiator and a thermal initiator that generates radicals at elevated temperatures. This mixture is generally dissolved in an organic solvent in order to enhance processing, e.g. formation of thin films by spin coating. The blending conditions as well as the properties of the polymer

and monomer are chosen such that after evaporation of the solvent a solid film is formed. In general this allows that upon patterned exposure with UV light a latent image is formed. The latent image can be developed into a surface profile by heating where polymerization and diffusion occur simultaneously, thus increasing the materials volume at the exposed area or vice versa which results in a surface deformation.

A weakness of this process is that the resulting relief structure, produced with such a photo-embossing process, has still a rather low aspect ratio, that needs further improvement for certain applications. The aspect ratio (AR) is defined as the ratio between the relief height and structure width. As a result of which the optical function or other functionality that is aimed at is less optimal.

Photoembossing processes are known from for example WO 2005/081071, WO2006/085741, and WO 2005/008321.

US2005/032997 describes a composition for making a photoresist. XP002457741 describes a photosensitive composition comprising an organic sulfur compound, a titanocene compound and polymerisable compounds. The sulfur compounds differ from the compounds used in the present application.

It has now been found that the presence of a reversible addition fragmentation chain transfer (RAFT) agent influences the AR of the polymeric relief structure in an unexpected way. It has been found that the AR can be improved with the application of certain amounts of RAFT agent. Both the absence of a RAFT agent and the presence of a too large amount of RAFT agent generate relief structures that have a low AR.

Additionally, it has now surprisingly been found that the process according to the present invention can be performed both at ambient conditions (under air, at room temperature) and under inert atmosphere. In both cases high aspect ratios can be obtained under these conditions.

The present invention relates to a photo-embossing process for the preparation of a polymeric relief structure comprising the steps

a) coating a substrate with a coating composition comprising one or more radiation-sensitive ingredients,
b) locally treating the coated substrate with electromagnetic radiation having a periodic or random radiation-intensity pattern, forming a latent image,
c) polymerizing and/or crosslinking the resulting coated substrate,

wherein the coating composition comprises a compound according to the formula I

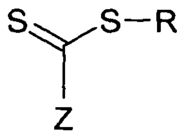

Formula (I)

wherein R is a substitued or unsubstituted aryl or alkyl group; Z is an organic group having from 1 to 100 C-atoms.

Another embodiment of the present invention is a photo-embossing process for the preparation of a polymeric relief structure comprising the steps

a) coating a substrate with a coating composition comprising one or more radiation-sensitive ingredients,
b) locally treating the coated substrate with electromagnetic radiation having a periodic or random radiation-intensity pattern, forming a latent image,
c) polymerizing and/or crosslinking the resulting coated substrate,

wherein the coating composition comprises a blend of at least one polymer, at least one monomer, a photoinitiator, optionally a solvent and one or more organic RAFT agents in an amount between 0.5 and 20 wt% (relative to the blend of polymer(s), monomer(s) and initiator(s)).

RAFT agents have been disclosed in several references, like for example WO99/31144, or Polymer International 49:993-1001 (2000). In these publications the RAFT agents are used for the controlled radical polymerization of different monomers. The application of RAFT agents in a process for preparing a polymeric relief structure has not been disclosed. The presence of the RAFT agent in the process of the invention gives unexpected effects of enhancing the AR of the polymeric relief structures to be made.

The RAFT agents to be used in the present invention have the general structure according to formula I:

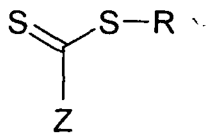

Formula (I)

wherein R = substitued or unsubstituted aryl or alkyl groups; Z= organic group having from 1 to 100 C-atoms and optionally heteroatoms like O, N, S, P, Si. Examples of organic groups Z are alkyl group, arylgroup, thiol, amine, pyrrole, pyridine, alkoxy , In a preferred embodiment of the invention R is a moiety having the formula $-C-(R_1)_2-Y$, wherein $R_1$ is an alkyl group selected from the group consisting of methyl, ethyl, propyl, isopropyl, butyl group, and Y is an aromatic group selected from the group consisting of phenyl, tolyl, naphtyl group, a CN, an ether group or an ester group. More preferably R is a $-C-(CH_3)_2-CN$, $-C-(CH_3)_2-Y2$ group, wherein Y2 is a phenyl, tolyl or naphtylgroup, or a $-C-(CH_3)_2-COOR_2$ group, wherein $R_2$ is a $C_1-C_{10}$ substituted or unsubstituted alkyl group. Most preferably R is chosen from the group consisting of $-C-(CH_3)_2-CN$, $-C-(CH_3)_2$-phenyl, $-C-(CH_3)_2$-tolyl, and $-C-(CH_3)_2-COOR_3$, wherein $R_3$ is methyl, ethyl, propyl or butyl.

It has been found that Z is preferably chosen from the group consisting of phenyl, tolyl, naphthyl, thiol, alkyl having from 1 to 10 carbon atoms, and pyrrol groups. More preferably Z is an aromatic group having from 6 to 20 carbon atoms. Most preferably, Z is a phenyl or tolyl group.

The amount of RAFT agent to be used generally lies between 0,1 and 20 weight %, relative to the blend of polymer(s), monomer(s) and initiator(s).

It has been found that the optimum amount of RAFT agent to be added to the composition depends on the amount of photoinitiator present in the composition of the invention, and the amount of dose used to make the polymeric relief structure. A R-factor is hereby defined to describe these relations.

$$\text{R-factor} = \frac{[\text{RAFT}]}{[\text{initiator}] * \text{Dose}}$$

wherein the [RAFT] is the wt% of RAFT agent in the composition (or compound according to formula I), [initiator] is the wt% of a photoinitiator in the composition, and Dose is the radiation dose applied to the composition during build of the structure (in $mJ.cm^{-2}$).

It has been found that the highest AR values can be obtained, when the R-factor ranges between 0,0001 and 0,005, preferably between 0,0005 and 0,004.

A linemask with fillfactor 0.5 is a mask comprising parallel lines, wherein 50% of the surface is non-transparant.

The coating used in step a) of the present process comprises one or more radiation sensitive ingredients, which in general are C=C unsaturated monomers, polymerizable via electromagnetic radiation. These ingredients can be used as such, but also in the form of a solution.

The coating may be applied onto the substrate by any process known in the art of (wet) coating deposition. Examples of suitable processes are spin coating, dip coating, spray coating, flow coating, meniscus coating, doctor's blading, capillary coating, and roll coating.

Typically, the radiation sensitive ingredients are mixed, preferably with at least one solvent and, optionally, crosslinking initiator to prepare a mixture that is suitable for application to the substrate using the chosen method of application.

In principle, a wide variety of solvents may be used. However, the combination of the solvents and all other materials present in the mixture should preferentially form stable suspensions or solutions.

Preferably the solvent used is evaporated after applying the coating onto the substrate. In the process according to the invention, optionally the coating may after application to the substrate be heated or treated in vacuum to aid evaporation of the solvent.

Examples of solvents that are suitable are 1,4-dioxane, acetone, acetonitrile, chloroform, chlorophenol, cyclohexane, cyclohexanone, cyclopentanone, dichloromethane, diethyl acetate, diethyl ketone, dimethyl carbonate,

dimethylformamide, dimethylsulphoxide, ethanol, ethyl acetate, m-cresol, mono- and di-alkyl substituted glycols, N,N-dimethylacetamide, p-chlorophenol, 1,2-propanediol, 1-pentanol, 1-propanol, 2-hexanone, 2-methoxyethanol, 2-methyl-2-propanol, 2-octanone, 2-propanol, 3-pentanone, 4-methyl-2-pentanone, hexafluoroisopropanol, methanol, methyl acetate, butyl acetate, methyl acetoacetate, methyl ethyl ketone, methyl propyl ketone, n-methylpyrrolidone-2, n-pentyl acetate, phenol, tetrafluoro-n-propanol, tetrafluoroisopropanol, tetrahydrofuran, toluene, xylene and water. Alcohol, ketone and ester based solvents may also be used, although the solubility of acrylates may become an issue with high molecular weight alcohols. Halogenated solvents (such as dichloromethane and chloroform) and hydrocarbons (such as hexanes and cyclohexanes), are suitable.

The mixtures preferably contain a polymeric material. In fact each polymer can be used that forms a homogenous mixture with the other components. Well-studied polymers are polymethylmethacrylate, polymethylacrylate, polystyrene, polybenzylmethacrylate, polyisobornylmethacrylate. But also many other polymers may be applied as well. The mixture also contains a monomeric compound, being a compound of relatively low molecular weight, i.e. smaller than 1500 daltons, that upon contact with reactive particles, i.e. free radicals or cationic particles, polymerize. In a preferred embodiment the monomer or one of the monomers of a monomer mixture contains more than one polymerizing group such that upon polymerization a polymer network is formed. Further in the preferred embodiment the monomers are molecules containing reactive group of the following classes: vinyl, acrylate, methacrylate, epoxide, vinylether, oxetane or thiol-ene. The mixture also contains a photosensitive component being the compound that upon exposure to actinic radiation generates the reactive particle, i.e. the free-radicals or cationic particles.

Examples of monomers suitable for use as polymerizing ingredient and having at least two crosslinkable groups per molecule include monomers containing (meth)acryloyl groups such as trimethylolpropane tri(meth)acrylate, pentaerythritol (meth)acrylate, ethylene glycol di(meth)acrylate, tetraethylene glycol di(meth)acrylate, polyethylene glycol di(meth)acrylate, 1,4-butanediol di(meth)acrylate, 1,6-hexanediol di(meth)acrylate, neopentyl glycol di(meth)acrylate, polybutanediol di(meth)acrylate, tripropyleneglycol di(meth)acrylate, glycerol tri(meth)acrylate, phosphoric acid mono- and di(meth)acrylates, $C_7$-$C_{20}$ alkyl di(meth)acrylates, trimethylolpropanetrioxyethyl (meth)acrylate, tris(2-hydroxyethyl) isocyanurate tri(meth)acrylate, tris(2-hydroxyethyl)isocyanurate di(meth)acrylate, pentaerythritol tri(meth)acrylate, pentaerythritol tetra(meth)acrylate, dipentaerythritol monohydroxy pentacrylate, dipentaerythritol hexacrylate, tricyclodecane diyl dimethyl di(meth)acrylate and alkoxylated versions, preferably ethoxylated and/or propoxylated, of any of the preceding monomers, and also di(meth)acrylate of a diol which is an ethylene oxide or propylene oxide adduct to bisphenol A, di(meth)acrylate of a diol which is an ethylene oxide or propylene oxide adduct to hydrogenated bisphenol A, epoxy (meth)acrylate which is a (meth)acrylate adduct to bisphenol A of diglycidyl ether, diacrylate of polyoxyalkylated bisphenol A, and triethylene glycol divinyl ether, adduct of hydroxyethyl acrylate, isophorone diisocyanate and hydroxyethyl acrylate (HIH), adduct of hydroxyethyl acrylate, toluene diisocyanate and hydroxyethyl acrylate (HTH), and amide ester acrylate.

Examples of suitable monomers having only one crosslinking group per molecule include monomers containing a vinyl group, such as N-vinyl pyrrolidone, N-vinyl caprolactam, vinyl imidazole, vinyl pyridine; isobornyl (meth)acrylate, bornyl (meth)acrylate, tricyclodecanyl (meth)acrylate, dicyclopentanyl (meth)acrylate, dicyclopentenyl (meth)acrylate, cyclohexyl (meth)acrylate, benzyl (meth)acrylate, 4-butylcyclohexyl (meth)acrylate, acryloyl morpholine, (meth)acrylic acid, 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, amyl (meth)acrylate, isobutyl (meth)acrylate, t-butyl (meth)acrylate, pentyl (meth)acrylate, caprolactone acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, tridecyl (meth)acrylate, undecyl (meth)acrylate, lauryl (meth)acrylate, stearyl (meth)acrylate, isostearyl (meth)acrylate, tetrahydrofurfuryl (meth)acrylate, butoxyethyl (meth)acrylate, ethoxydiethylene glycol (meth)acrylate, benzyl (meth)acrylate, phenoxyethyl (meth)acrylate, polyethylene glycol mono(meth)acrylate, polypropylene glycol mono(meth)acrylate, methoxyethylene glycol (meth)acrylate, ethoxyethyl (meth)acrylate, methoxypolyethylene glycol (meth)acrylate, methoxypolypropylene glycol (meth)acrylate, diacetone (meth)acrylamide, beta-carboxyethyl (meth)acrylate, phthalic acid (meth)acrylate, isobutoxymethyl (meth) acrylamide, N,N-dimethyl (meth)acrylamide, t-octyl (meth)acrylamide, dimethylaminoethyl (meth)acrylate, diethylaminoethyl (meth)acrylate, butylcarbamylethyl (meth)acrylate, n-isopropyl (meth)acrylamide fluorinated (meth)acrylate, 7-amino-3,7-dimethyloctyl (meth)acrylate, N,N-diethyl (meth)acrylamide, N,N-dimethylaminopropyl (meth)acrylamide, hydroxybutyl vinyl ether, lauryl vinyl ether, cetyl vinyl ether, 2-ethylhexyl vinyl ether; and compounds represented by the following formula (I)

$$CH_2=C(R^6)\text{-}COO(R^7O)_m\text{-}R^8 \qquad (I)$$

wherein $R^6$ is a hydrogen atom or a methyl group; $R^7$ is an alkylene group containing 2 to 8, preferably 2 to 5 carbon atoms; and m is an integer from 0 to 12, and preferably from 1 to 8; $R^8$ is a hydrogen atom or an alkyl group containing 1 to 12, preferably 1 to 9, carbon atoms; or, $R^8$ is a tetrahydrofuran group- comprising alkyl group with 4-20 carbon

atoms, optionally substituted with alkyl groups with 1-2 carbon atoms; or $R^8$ is a dioxane group-comprising alkyl group with 4-20 carbon atoms, optionally substituted with methyl groups; or $R^8$ is an aromatic group, optionally substituted with $C_1$-$C_{12}$ alkyl group, preferably a $C_8$-$C_9$ alkyl group, and alkoxylated aliphatic monofunctional monomers, such as ethoxylated isodecyl (meth)acrylate, ethoxylated lauryl (meth)acrylate.

Oligomers suitable for use as a radiation sentitive ingredient are for example aromatic or aliphatic urethane acrylates or oligomers based on phenolic resins (ex. bisphenol epoxy diacrylates), and any of the above oligomers chain extended with ethoxylates. Urethane oligomers may for example be based on a polyol backbone, for example polyether polyols, polyester polyols, polycarbonate polyols, polycaprolactone polyols, acrylic polyols. These polyols may be used either individually or in combinations of two or more. There are no specific limitations to the manner of polymerization of the structural units in these polyols. Any of random polymerization, block polymerization, or graft polymerization is acceptable. Examples of suitable polyols, polyisocyanates and hydroxylgroup-containing (meth)acrylates for the formation of urethane oligomers are disclosed in WO 00/18696.

Combinations of compounds that together may result in the formation of a crosslinked phase and thus in combination are suitable to be used as the reactive diluent are for example carboxylic acids and/or carboxylic anhydrides combined with epoxies, acids combined with hydroxy compounds, especially 2-hydroxyalkylamides, amines combined with isocyanates, for example blocked isocyanate, uretdion or carbodiimide, epoxies combined with amines or with dicyandiamides, hydrazinamides combined with isocyanates, hydroxy compounds combined with isocyanates, for example blocked isocyanate, uretdion or carbodiimide, hydroxy compounds combined with anhydrides, hydroxy compounds combined with (etherified) methylolamide ("amino-resins"), thiols combined with isocyanates, thiols combined with acrylates or other vinylic species (optionally radical initiated), acetoacetate combined with acrylates, and when cationic crosslinking is used epoxy compounds with epoxy or hydroxy compounds.

Further possible compounds that may be used as a radiation sensitive ingredient are moisture curable isocyanates, moisture curable mixtures of alkoxy/acyloxy-silanes, alkoxy titanates, alkoxy zirconates, or urea-, urea/melamine-, melamine- formaldehyde or phenol-formaldehyde (resol, novolac types), or radical curable (peroxide- or photo-initiated) ethylenically unsaturated mono- and polyfunctional monomers and polymers, e.g. acrylates, methacrylates, maleate/vinyl ether), or radical curable (peroxide- or photo-initiated) unsaturated e.g. maleic or fumaric, polyesters in styrene and/or in methacrylates.

Preferably, the applied coating also comprises a polymer, preferably of the same nature as the polymer resulting from the crosslinking of the radiation sensitive ingredients. Preferably, this polymer has a weight-averaged molecular weight (Mw) of at least 20,000 g/mol.

The polymer, when used in the coating step a), preferably has a glass transition temperature of at least 300 K. Preferably, the polymer in the coating used in step a) is dissolved in the monomer(s), present in the radiation sensitive coating of step a) or in the solvent used in the coating of step a) of the process of the present invention.

A wide variety of substrates may be used as a substrate in the process according to the invention. Suitable substrates are for example flat or curved, rigid or flexible polymeric substrates, including films of for example polycarbonate, polyester, polyvinyl acetate, polyvinyl pyrollidone, polyvinyl chloride, polyimide, polyethylene naphthalate, polytetrafluoro-ethylene, nylon, polynorbornene or amorphous solids, for example glass or crystalline materials, such as for example silicon or gallium arsenide. Metallic substrates may also be used. Preferred substrates for use in display applications are for example glass, polynorbornene, polyethersulfone, polyethyleneterephtalate, polyimide, cellulose triacetate, polycarbonate and polyethylenenaphthalate.

An initiator may be present in the coating to initiate the crosslinking reaction. The initiator preferably is a radical photoinitiator. The amount of initiator may vary between wide ranges. A suitable amount of initiator is for example between above 0 and 10 wt% with respect to total weight of the compounds that take part in the crosslinking reaction.

When UV-crosslinking is used to initiate crosslinking, the mixture preferably comprises a UV-photo-initiator. A photo-initiator is capable of initiating a crosslinking reaction upon absorption of light; thus, UV-photo-initiators absorb light in the Ultra-Violet region of the spectrum. Any known UV-photo-initiators may be used in the process according to the invention.

Preferably the polymerization initiator comprises a mixture of a photo initiator and a thermal initiator.

Any cross-linking method that may cause the coating to polymerize and/or crosslink so that a final coating is formed is suitable to be used in the process according to the invention. Suitable ways to initiate crosslinking are for example electron beam radiation, electromagnetic radiation (UV, Visible and Near IR), thermally and by adding moisture, in case moisture-curable compounds are used. In a preferred embodiment crosslinking is achieved-by UV-radiation. The UV-crosslinking may take place through a free radical mechanism or by a cationic mechanism, or a combination thereof. In another preferred embodiment the crosslinking is achieved thermally.

In step b) of the process of the present invention the coated substrate resulting form process step a) is locally treated with electromagnetic radiation having a periodic or latent radiation intensity pattering as a result of which a latent image is formed. In one preferred embodiment, this treatment is performed using UV-light in combination with a mask. In another preferred embodiment, this treatment is performed by the use of light interference/ holography. Still another

embodiment is by the use of electron beam lithography.

The essential feature of the present invention is the use of a RAFT agent in an appropriate amount to exactly tune the rate of polymerization or inhibition time or both for generating relief structures with a high aspect ratio.

The conditions under which the process steps a)- d) have to be performed, are as such known in the art of radiation polymerization. As temperatures for said process steps preferably a temperature of between 175 and 375 K is used for step b), and preferably a temperature of between 300 and 575 K is used for step c).

It has been found that the AR of the polymeric relief structure can be further improved by increasing the UV exposure dose. The optimum amount of RAFT agent generally increases when a higher dose of exposure is used. The combination of a higher exposure dose and a higher RAFT agent concentration has resulted in a further improvement of the process of the present invention.

The polymeric relief structures of the present invention have an improved aspect ratio. The aspect ratio (AR, being the ratio between the relief height and structure width, both in μm) of the reliefs of the invention is in general at least 0.075, and more preferably at least 0.12; even more preferably, the AR is at least 0.2.

The polymeric relief structures of the present invention are applicable in optical components. Examples thereof are quarter wave films and wire grid polarizes for applications in, e.g. LCD's or LED's. Also moth eye or lotus flower structures for self-cleaning surfaces are attainable herewith. Another and preferred embodiment is the use of the polymeric relief structure as a master for replication purposes in organic or inorganic matter. Other applications comprise Anti reflective/anti glare layers; vertically aligned displays (where photo-embossing is used to create the protrusions for alignment of the LCs); Microlenses; Reflectors, transflectors; polarizers; protein arrays, DNA arrays and microcontact printing

The invention is further elucidated with the following Examples and comparative experiments, which are not meant to restrict the invention.

EXAMPLES

Examples have been carried out with the following RAFT agents:

1) 2-cyanobut-2-yl dithiobenzoate:

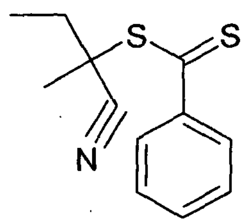

2) 2-(methoxycarbonyl)prop-2-yl dithiobenzoate:

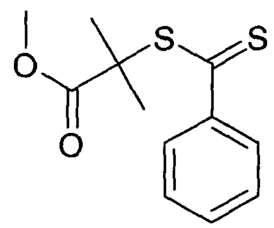

3) 2-phenylprop-2-yl phenyl dithioacetate:

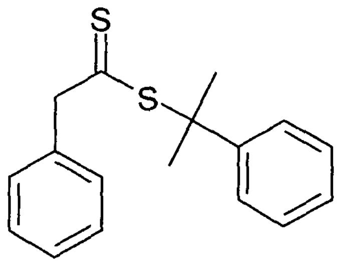

4) 2-*n*-dodecylsulfanylthiocarbonylsulfanyl-2-methylpropionic acid:

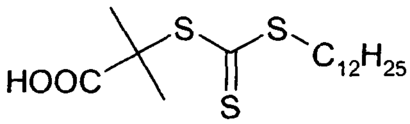

Comparative example 1: (air)

The photopolymer consisted of a mixture containing: 50 wt% of polymer, polybenzylmethacrylate (Mw = 70 kg/mol), and 50 wt% of a multifunctional monomer, di-penta erythritol penta/hexa acrylate. To the photopolymer was added 5 wt% of a photo-initiator (Irgacure 819). The mixture of photopolymer and photoinitiator was dissolved in 50 wt% of a 1:1 mixture of propylene glycol methyl ether acetate and ethoxypropylacetate. From now on this mixture will be called the photopolymer solution.

The photopolymer solution is spin-coated onto a glass substrate at 800 RPM. After spin-coating, the sample is heated to 80 °C in order to remove residual traces of solvent resulting in a film of approximately 16 μm thickness.

Then a photo mask with multiple gratings (pitch of 5, 8, 10, 15, 20, 30 and 40 μm) was used in direct contact with the solid polymer film. An exposure to ultra-violet light (EXFO OmniCureTM Series 2000, Photonic Solutions Inc., Ontario, Canada) was performed, with a energy dose of 2.34 $J.cm^{-2}$. After exposure to UV light, the sample was heated to 110 °C for 20 minutes to generate the relief structures. Finally a flood exposure was performed with a UV lamp (E=0.8 $J.cm^{-2}$) at 110°C to fix the sample.

The final formed relief structures were characterized by white light scanning confocal microscopy (μSurf, Nanofocus, Germany) using a 20x objective. The profiles were further characterized using Scanning Probe Image Processor, SPIP™ software, version 4.1. The relief structures are summarized in Table 1. Values of then height of the relief structures have been indicated in nm. The maximum aspect ratio was approximately 0.13.

Table 1

| | Exposure Dose [$mJ.cm^{-2}$] | | | | | | |
|---|---|---|---|---|---|---|---|
| Pitch [μm] | 23.4 | 46.8 | 117 | 257.4 | 491.4 | 1193.4 | 2106 |
| 5 | 0 | 0.00 | 0.01 | 0.02 | 0.02 | 0.01 | 0.00 |
| 8 | 0 | 0.01 | 0.03 | 0.06 | 0.05 | 0.04 | 0.01 |
| 10 | 0 | 0.00 | 0.02 | 0.08 | 0.04 | 0.02 | 0.01 |
| 15 | 0 | 0.01 | 0.04 | 0.07 | 0.05 | 0.03 | 0.04 |
| 20 | 0 | 0.01 | 0.06 | 0.09 | 0.07 | 0.04 | 0.04 |
| 30 | 0 | 0.02 | 0.11 | 0.12 | 0.07 | 0.05 | 0.04 |
| 40 | 0 | 0.02 | 0.13 | 0.11 | 0.07 | 0.04 | 0.04 |

Comparative example 2: (nitrogen)

The experimental conditions of comparative example 1 were used. Both during the illumination and during the heating step, the film kept under a nitrogen atmosphere. The maximum height of the structures was determined using an optical profilometer and the results are shown below in Table 2. The maximum aspect ratio was approximately 0.05.

Table 2

| | Exposure Dose [mJ.cm$^{-2}$] | | | | | | |
|---|---|---|---|---|---|---|---|
| Pitch [μm] | 23.4 | 46.8 | 117 | 257.4 | 491.4 | 1193.4 | 2106 |
| 5 | 0.03 | 0.04 | 0.02 | 0.02 | 0.01 | 0.01 | 0.01 |
| 8 | 0.04 | 0.04 | 0.03 | 0.03 | 0.02 | 0.02 | 0.02 |
| 10 | 0.04 | 0.05 | 0.04 | 0.04 | 0.03 | 0.03 | 0.02 |
| 15 | 0.03 | 0.04 | 0.04 | 0.04 | 0.04 | 0.04 | 0.03 |
| 20 | 0.03 | 0.03 | 0.04 | 0.05 | 0.05 | 0.04 | 0.03 |
| 30 | 0.02 | 0.02 | 0.03 | 0.04 | 0.04 | 0.04 | 0.04 |
| 40 | 0.02 | 0.02 | 0.02 | 0.03 | 0.03 | 0.04 | 0.03 |

Comparative example 1 and 2 that in the absence of a RAFT agent, maximum aspect ratios between 0.05 and 0.13 can be achieved.

Example 1: (2-cyanobut-2-yl dithiobenzoate)

The experimental conditions of comparative example 1 were used. An amount of 2-cyanobut-2-yl dithiobenzoate was added to the photopolymer solution before processing. The RAFT agent to initiator ratio was successively changed from 0.1 - 8. During both the illumination and heating step, the film was kept in an air atmosphere. The structure heights determined using an optical profilometer for a RAFT to initiator ration of 0.1, 0.2, 0.5, 1, 2, 4 and 8 are shown below in Table 3-9, respectively. The relief structures showed a maximum aspect ratio of approximately 0.32 when a RAFT agent to initiator ratio of 2 is used.

**Table 3.** RAFT agent to initiator ratio is 0.1.

| | Exposure Dose [mJ.cm$^{-2}$] | | | | | | |
|---|---|---|---|---|---|---|---|
| Pitch [μm] | 23.4 | 46.8 | 117 | 257.4 | 491.4 | 1193.4 | 2106 |
| 5 | 0.00 | 0.00 | 0.08 | 0.08 | 0.07 | 0.04 | 0.01 |
| 8 | 0.00 | 0.01 | 0.12 | 0.15 | 0.06 | 0.06 | 0.04 |
| 10 | 0.00 | 0.01 | 0.14 | 0.17 | 0.08 | 0.06 | 0.04 |
| 15 | 0.00 | 0.02 | 0.19 | 0.19 | 0.12 | 0.08 | 0.05 |
| 20 | 0.00 | 0.03 | 0.21 | 0.18 | 0.13 | 0.08 | 0.06 |
| 30 | 0.00 | 0.04 | 0.19 | 0.15 | 0.11 | 0.08 | 0.06 |
| 40 | 0.00 | 0.02 | 0.16 | 0.12 | 0.09 | 0.07 | 0.05 |
| R-factor | 0.004 | 0.002 | 0.0009 | 0.0004 | 0.0002 | 0.00008 | 0.00004 |

**Table 4.** RAFT agent to initiator ratio is 0.2.

| | Exposure Dose [mJ.cm$^{-2}$] | | | | | | |
|---|---|---|---|---|---|---|---|
| Pitch [μm] | 23.4 | 46.8 | 117 | 257.4 | 491.4 | 1193.4 | 2106 |
| 5 | 0.00 | 0.00 | 0.07 | 0.05 | 0.03 | 0.02 | 0.01 |

(continued)

| | Exposure Dose [mJ.cm$^{-2}$] | | | | | | |
|---|---|---|---|---|---|---|---|
| Pitch [μm] | 23.4 | 46.8 | 117 | 257.4 | 491.4 | 1193.4 | 2106 |
| 8 | 0.00 | 0.01 | 0.06 | 0.07 | 0.08 | 0.04 | 0.03 |
| 10 | 0.00 | 0.01 | 0.10 | 0.25 | 0.12 | 0.07 | 0.01 |
| 15 | 0.00 | 0.02 | 0.23 | 0.17 | 0.17 | 0.09 | 0.03 |
| 20 | 0.00 | 0.11 | 0.26 | 0.18 | 0.15 | 0.08 | 0.07 |
| 30 | 0.00 | 0.14 | 0.20 | 0.13 | 0.10 | 0.08 | 0.08 |
| 40 | 0.00 | 0.13 | 0.15 | 0.10 | 0.08 | 0.07 | 0.08 |
| R-factor | 0.0085 | 0.0021 | 0.0017 | 0.0008 | 0.0004 | 0.0002 | 0.0001 |

**Table 5.** RAFT agent to initiator ratio is 0.5.

| | Exposure Dose [mJ.cm$^{-2}$] | | | | | | |
|---|---|---|---|---|---|---|---|
| Pitch [μm] | 23.4 | 46.8 | 117 | 257.4 | 491.4 | 1193.4 | 2106 |
| 5 | 0.00 | 0.00 | 0.02 | 0.04 | 0.03 | 0.02 | 0.04 |
| 8 | 0.00 | 0.00 | 0.05 | 0.09 | 0.08 | 0.09 | 0.04 |
| 10 | 0.00 | 0.00 | 0.09 | 0.16 | 0.18 | 0.10 | 0.06 |
| 15 | 0.00 | 0.00 | 0.13 | 0.27 | 0.22 | 0.14 | 0.07 |
| 20 | 0.00 | 0.01 | 0.11 | 0.28 | 0.23 | 0.15 | 0.08 |
| 30 | 0.00 | 0.03 | 0.13 | 0.23 | 0.19 | 0.13 | 0.09 |
| 40 | 0.00 | 0.03 | 0.15 | 0.18 | 0.15 | 0.11 | 0.08 |
| R-factor | 0.021 | 0.011 | 0.004 | 0.002 | 0.001 | 0.0004 | 0.0002 |

**Table 6.** RAFT agent to initiator ratio is 1.

| | Exposure Dose [mJ.cm$^{-2}$] | | | | | | |
|---|---|---|---|---|---|---|---|
| Pitch [μm] | 23.4 | 46.8 | 117 | 257.4 | 491.4 | 1193.4 | 2106 |
| 5 | 0.00 | 0.00 | 0.00 | 0.00 | 0.00 | 0.00 | 0.00 |
| 8 | 0.00 | 0.00 | 0.00 | 0.01 | 0.01 | 0.02 | 0.02 |
| 10 | 0.00 | 0.00 | 0.01 | 0.02. | 0.01 | 0.05 | 0.03 |
| 15 | 0.00 | 0.00 | 0.00 | 0.03 | 0.04 | 0.11 | 0.03 |
| 20 | 0.00 | 0.00 | 0.01 | 0.06 | 0.13 | 0.15 | 0.11 |
| 30 | 0.00 | 0.00 | 0.03 | 0.07 | 0.20 | 0.18 | 0.11 |
| 40 | 0.00 | 0.00 | 0.03 | 0.08 | 0.19 | 0.15 | 0.11 |
| R-factor | 0.042 | 0.021 | 0.0085 | 0.0039 | 0.0020 | 0.0008 | 0.0005 |

**Table 7.** RAFT agent to initiator ratio is 2.

| | Exposure Dose [mJ.cm$^{-2}$] | | | | | | |
|---|---|---|---|---|---|---|---|
| Pitch [μm] | 23.4 | 46.8 | 117 | 257.4 | 491.4 | 1193.4 | 2106 |
| 5 | 0.00 | 0.00 | 0.00 | 0.00 | 0.01 | 0.03 | 0.02 |

(continued)

| | Exposure Dose [mJ.cm-2] | | | | | | |
|---|---|---|---|---|---|---|---|
| Pitch [μm] | 23.4 | 46.8 | 117 | 257.4 | 491.4 | 1193.4 | 2106 |
| 8 | 0.00 | 0.00 | 0.00 | 0.00 | 0.01 | 0.01 | 0.07 |
| 10 | 0.00 | 0.00 | 0.00 | 0.01 | 0.03 | 0.07 | 0.11 |
| 15 | 0.00 | 0.00 | 0.00 | 0.02 | 0.08 | 0.26 | 0.18 |
| 20 | 0.00 | 0.00 | 0.00 | 0.03 | 0.07 | 0.32 | 0.24 |
| 30 | 0.00 | 0.00 | 0.00 | 0.05 | 0.13 | 0.27 | 0.23 |
| 40 | 0.00 | 0.00 | 0.00 | 0.04 | 0.17 | 0.22 | 0.19 |
| R-factor | 0.085 | 0.043 | 0.017 | 0.0078 | 0.0040 | 0.0016 | 0.0009 |

**Table 8.** RAFT agent to initiator ratio is 4.

| | Exposure Dose [mJ.cm-2] | | | | | | |
|---|---|---|---|---|---|---|---|
| Pitch [μm] | 23.4 | 46.8 | 117 | 257.4 | 491.4 | 1193.4 | 2106 |
| 5 | 0.00 | 0.00 | 0.00 | 0.00 | 0.00 | 0.01 | 0.06 |
| 8 | 0.00 | 0.00 | 0.00 | 0.00 | 0.00 | 0.04 | 0.09 |
| 10 | 0.00 | 0.00 | 0.00 | 0.00 | 0.00 | 0.04 | 0.12 |
| 15 | 0.00 | 0.00 | 0.00 | 0.00 | 0.00 | 0.05 | 0.11 |
| 20 | 0.00 | 0.00 | 0.00 | 0.00 | 0.00 | 0.05 | 0.11 |
| 30 | 0.00 | 0.00 | 0.00 | 0.00 | 0.00 | 0.05 | 0.17 |
| 40 | 0.00 | 0.00 | 0.00 | 0.00 | 0.00 | 0.04 | 0.19 |
| R-factor | 0.17 | 0.085 | 0.034 | 0.016 | 0.0081 | 0.003 | 0.002 |

**Table 9.** RAFT agent to initiator ratio is 8.

| | Exposure Dose [mJ.cm-2] | | | | | | |
|---|---|---|---|---|---|---|---|
| Pitch [μm] | 23.4 | 46.8 | 117 | 257.4 | 491.4 | 1193.4 | 2106 |
| 5 | 0 | 0 | 0 | 0 | 0 | 0 | 0 |
| 8 | 0 | 0 | 0 | 0 | 0 | 0 | 0 |
| 10 | 0 | 0 | 0 | 0 | 0 | 0 | 0 |
| 15 | 0 | 0 | 0 | 0 | 0 | 0 | 0 |
| 20 | 0 | 0 | 0 | 0 | 0 | 0 | 0 |
| 30 | 0 | 0 | 0 | 0 | 0 | 0 | 0 |
| 40 | 0 | 0 | 0 | 0 | 0 | 0 | 0 |
| R-factor | 0.34 | 0.17 | 0.068 | 0.032 | 0.016 | 0.0067 | 0.0038 |

Furthermore, when plotting the RAFT agent to initiator ratio for the maximum structure height (20 μm pitch) as function of dose, a linear relation can be obtained. The graph shows that using a higher dose requires a higher concentration of RAFT agent (with respect to the initiator) to obtain optimal results. It is believed that a higher irradiation dose initiates more initiator radicals, and therefore, more RAFT agents are necessary to slow down the radicals upon reacting with monomeric species.

Example 2: (2-cyanobut-2-yl dithiobenzoate)

The experimental conditions of example 1 were used, except that an inert atmosphere was used during the experiment. An amount of 2-cyanobut-2-yl dithiobenzoate was added to the photopolymer solution before processing. The RAFT agent to initiator ratio was successively changed from 0.2 - 1. During both the illumination and heating step, the film was kept in an inert atmosphere. The structure heights determined using an optical profilometer for a RAFT to initiator ration of 0.2, 0.5 and 1 are shown below in Table 10-12, respectively. The relief structures showed a maximum aspect ratio of approximately 0.42 when a RAFT agent to initiator ratio of 0.5 is used.

**Table 10.** RAFT agent to initiator ratio is 0.2.

| | Exposure Dose [mJ.cm$^{-2}$] | | | | | | |
|---|---|---|---|---|---|---|---|
| Pitch [μm] | 23.4 | 46.8 | 117 | 257.4 | 491.4 | 1193.4 | 2106 |
| 5 | 0.02 | 0.00 | 0.00 | 0.02 | 0.03 | 0.00 | 0.00 |
| 8 | 0.03 | 0.02 | 0.03 | 0.03 | 0.04 | 0.06 | 0.00 |
| 10 | 0.04 | 0.02 | 0.03 | 0.02 | 0.06 | 0.07 | 0.00 |
| 15 | 0.05 | 0.04 | 0.05 | 0.06 | 0.07 | 0.09 | 0.00 |
| 20 | 0.06 | 0.05 | 0.06 | 0.06 | 0.08 | 0.11 | 0.00 |
| 30 | 0.06 | 0.04 | 0.05 | 0.05 | 0.06 | 0.08 | 0.00 |
| 40 | 0.06 | 0.03 | 0.03 | 0.04 | 0.04 | 0.04 | 0.00 |
| R-factor | 0.0085 | 0.0021 | 0.0017 | 0.0008 | 0.0004 | 0.0002 | 0.0001 |

**Table 11.** RAFT agent to initiator ratio is 0.5.

| | Exposure Dose [mJ.cm$^{-2}$] | | | | | | |
|---|---|---|---|---|---|---|---|
| Pitch [μm] | 23.4 | 46.8 | 117 | 257.4 | 491.4 | 1193.4 | 2106 |
| 5 | 0.01 | 0.01 | 0.01 | 0.02 | 0.04 | 0.05 | 0.02 |
| 8 | 0.03 | 0.03 | 0.03 | 0.04 | 0.07 | 0.11 | 0.10 |
| 10 | 0.03 | 0.04 | 0.04 | 0.05 | 0.08 | 0.20 | 0.14 |
| 15 | 0.04 | 0.05 | 0.06 | 0.08 | 0.17 | 0.42 | 0.19 |
| 20 | 0.05 | 0.05 | 0.08 | 0.12 | 0.20 | 0.31 | 0.19 |
| 30 | 0.04 | 0.05 | 0.08 | 0.09 | 0.11 | 0.18 | 0.15 |
| 40 | 0.03 | 0.04 | 0.05 | 0.06 | 0.07 | 0.16 | 0.11 |
| R-factor | 0.021 | 0.011 | 0.004 | 0.002 | 0.001 | 0.0004 | 0.0002 |

**Table 12.** RAFT agent to initiator ratio is 1.

| | Exposure Dose [mJ.cm$^{-2}$] | | | | | | |
|---|---|---|---|---|---|---|---|
| Pitch [μm] | 23.4 | 46.8 | 117 | 257.4 | 491.4 | 1193.4 | 2106 |
| 5 | 0.01 | 0.01 | 0.02 | 0.03 | 0.02 | 0.01 | 0.00 |
| 8 | 0.03 | 0.04 | 0.03 | 0.10 | 0.13 | 0.04 | 0.02 |
| 10 | 0.04 | 0.05 | 0.05 | 0.25 | 0.22 | 0.04 | 0.02 |
| 15 | 0.06 | 0.06 | 0.11 | 0.39 | 0.33 | 0.07 | 0.02 |
| 20 | 0.06 | 0.07 | 0.16 | 0.36 | 0.33 | 0.05 | 0.02 |
| 30 | 0.06 | 0.08 | 0.13 | 0.24 | 0.23 | 0.08 | 0.02 |

(continued)

| | Exposure Dose [mJ.cm-2] | | | | | | |
|---|---|---|---|---|---|---|---|
| Pitch [μm] | 23.4 | 46.8 | 117 | 257.4 | 491.4 | 1193.4 | 2106 |
| 40 | 0.05 | 0.06 | 0.09 | 0.16 | 0.17 | 0.09 | 0.04 |
| R-factor | 0.042 | 0.021 | 0.0085 | 0.0039 | 0.0020 | 0.0008 | 0.0005 |

Example 3: (2-(methoxycarbonyl)prop-2-yl dithiobenzoate)

The experimental conditions of comparative example 1 were used. An amount of 2-(methoxycarbonyl)prop-2-yl dithiobenzoate was added to the photopolymer solution before processing, so that the ratio of RAFT to initiator was 2:1. During both the illumination and heating step, the film was kept in an air atmosphere. The structure heights determined using an optical profilometer are shown below in Table 13. The maximum aspect ratio was approximately 0.23.

**Table 13.** RAFT agent to initiator ratio is 2.

| | Exposure Dose [mJ.cm-2] | | | | | | |
|---|---|---|---|---|---|---|---|
| Pitch [μm] | 23.4 | 46.8 | 117 | 257.4 | 491.4 | 1193.4 | 2106 |
| 5 | 0.00 | 0.00 | 0.00 | 0.01 | 0.02 | 0.02 | 0.01 |
| 8 | 0.00 | 0.00 | 0.00 | 0.02 | 0.07 | 0.05 | 0.05 |
| 10 | 0.00 | 0.00 | 0.01 | 0.02 | 0.03 | 0.06 | 0.07 |
| 15 | 0.00 | 0.00 | 0.01 | 0.03 | 0.06 | 0.12 | 0.08 |
| 20 | 0.00 | 0.00 | 0.02 | 0.06 | 0.23 | 0.16 | 0.10 |
| 30 | 0.00 | 0.00 | 0.03 | 0.06 | 0.23 | 0.18 | 0.11 |
| 40 | 0.00 | 0.00 | 0.03 | 0.05 | 0.20 | 0.13 | 0.09 |
| R-factor | 0.085 | 0.043 | 0.017 | 0.0078 | 0.0040 | 0.0016 | 0.0009 |

Example 4: (2-phenylprop-2-yl phenyl dithioacetate)

The experimental conditions of comparative example 1 were used. An amount of 2-phenylprop-2-yl phenyl dithioacetate was added to the photopolymer solution before processing, so that the ratio of RAFT to initiator was 2:1. During both the illumination and heating step, the film was kept in an air atmosphere. The structure heights determined using an optical profilometer are shown below in Table 14. The maximum aspect ratio was approximately 0.08.

**Table 14.** RAFT agent to initiator ratio is 2.

| | Exposure Dose [mJ.cm-2] | | | | | | |
|---|---|---|---|---|---|---|---|
| Pitch [μm] | 23.4 | 46.8 | 117 | 257.4 | 491.4 | 1193.4 | 2106 |
| 5 | 0.00 | 0.00 | 0.00 | 0.00 | 0.01 | 0.01 | 0.00 |
| 8 | 0.00 | 0.00 | 0.00 | 0.01 | 0.01 | 0.01 | 0.03 |
| 10 | 0.00 | 0.00 | 0.00 | 0.01 | 0.02 | 0.04 | 0.05 |
| 15 | 0.00 | 0.00 | 0.01 | 0.03 | 0.03 | 0.06 | 0.05 |
| 20 | 0.00 | 0.00 | 0.02 | 0.03 | 0.04 | 0.07 | 0.06 |
| 30 | 0.00 | 0.00 | 0.02 | 0.04 | 0.05 | 0.08 | 0.06 |
| 40 | 0.00 | 0.00 | 0.03 | 0.04 | 0.06 | 0.08 | 0.06 |
| R-factor | 0.085 | 0.043 | 0.017 | 0.0078 | 0.0040 | 0.0016 | 0.0009 |

Example 5: (2-n-dodecylsulfanylthiocarbonylsulfanyl-2-methylpropionic acid)

The experimental conditions of comparative example 1 were used. An amount of 2-*n*-dodecylsulfanylthiocarbonylsulfanyl-2-methylpropionic acid was added to the photopolymer solution before processing, so that the ratio of RAFT to initiator was 2:1. During both the illumination and heating step, the film was kept in an air atmosphere. The structure heights determined using an optical profilometer are shown below in Table 15. The maximum aspect ratio was approximately 0.11.

**Table 15.** RAFT agent to initiator ratio is 2.

| | Exposure Dose [mJ.cm$^{-2}$] | | | | | | |
|---|---|---|---|---|---|---|---|
| Pitch [μm] | 23.4 | 46.8 | 117 | 257.4 | 491.4 | 1193.4 | 2106 |
| 5 | 0.00 | 0.00 | 0.00 | 0.00 | 0.01 | 0.01 | 0.01 |
| 8 | 0.00 | 0.00 | 0.00 | 0.00 | 0.03 | 0.03 | 0.01 |
| 10 | 0.00 | 0.00 | 0.01 | 0.01 | 0.06 | 0.06 | 0.00 |
| 15 | 0.00 | 0.00 | 0.01 | 0.02 | 0.04 | 0.09 | 0.04 |
| 20 | 0.00 | 0.00 | 0.02 | 0.03 | 0.04 | 0.10 | 0.06 |
| 30 | 0.00 | 0.00 | 0.02 | 0.04 | 0.05 | 0.11 | 0.08 |
| 40 | 0.00 | 0.00 | 0.02 | 0.04 | 0.05 | 0.10 | 0.06 |
| R-factor | 0.085 | 0.043 | 0.017 | 0.0078 | 0.0040 | 0.0016 | 0.0009 |

## Claims

**1.** Photo-embossing process for the preparation of a polymeric relief structure comprising the steps

a) coating a substrate with a coating composition comprising one or more radiation-sensitive ingredients,
b) locally treating the coated substrate with electromagnetic radiation having a periodic or random radiation-intensity pattern, forming a latent image,
c) polymerizing and/or crosslinking the resulting coated substrate,

wherein the coating composition comprises a compound according to the formula I

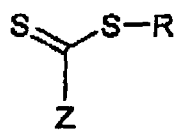

Formula (I)

wherein R is a substitued or unsubstituted aryl or alkyl group; Z is an organic group having from 1 to 100 C-atoms.

**2.** The process according to claim 1, wherein R is a having the formula -C- moiety $(R_1)_2$-Y, wherein $R_1$ is an alkyl group selected from the group consisting of methyl, ethyl, propyl, isopropyl and butyl, and wherein Y is an aromatic group selected from the group consisting of phenyl, tolyl and naphtyl, or a CN group; or an ether group; or an ester group.

**3.** The process according to claim 1, wherein R is a $-C-(CH_3)_2-CN$, $-C-(CH_3)_2$-Y2 group, wherein Y2 is a phenyl, tolyl or naphtylgroup, or a $-C-(CH_3)_2-COOR_2$ group, wherein $R_2$ is a $C_1$-$C_{10}$ substituted or unsubstituted alkyl group.

**4.** the process according to anyone of claims 1-3, wherein R is chosen from the group consisting of $-C-(CH_3)_2-CN$, $-C-(CH_3)_2$-phenyl, $-C-(CH_3)_2$-tolyl, and $-C-(CH_3)_2-COOR_3$, wherein $R_3$ is methyl, ethyl, propyl or butyl.

**5.** The process according to anyone of claims 1-4, wherein Z is chosen from the group consisting of phenyl, tolyl,

naphthyl, thiol, alkyl having from 1 to 10 carbon atoms, and pyrrol groups.

6. The process according to anyone of claims 1-5, wherein Z is an aromatic group having from 6 to 20 carbon atoms.

7. The process according to anyone of claims 1-6, wherein Z is a phenyl or tolyl group,

8. The process according to anyone of claims 1-7, wherein the coating composition comprises a blend of at least one polymer, at least one monomer, a photoinitiator and a compound according to formula I in an amount between 0.1 and 20 wt% (relative to the blend of polymer(s), monomer(s) and initiator(s)).

9. The process according to claim 8, wherein the amount of compound according to formula I, the photoinitiator concentration and the amount of electromagnetic irradiation are related to each other according to the formula

$$\text{R-factor} = \frac{[\text{RAFT}]}{[\text{initiator}] * \text{Dose}}$$

wherein the [RAFT] is the wt% of reversible addition fragmentation chain transfer agent according to formula I, [initiator] is the wt% of photoinitiator In the composition, and Dose is the radiation dose applied to the composition during build of the structure (in $mJ.cm^{-2}$), and wherein R-factor ranges between 0,0001 and 0,005.

10. The process according to claim 9, wherein the R-factor ranges between 0,0005 and 0.004.

11. The process according to anyone of claims 1 to 10, wherein step b) and c) are combined.

12. The process according to anyone of claims 1-11, wherein the solvent is removed between step a) and b).

13. Article comprising a polymeric relief structure as prepared according to a process as claimed In anyone of claims 1-12.

14. Optical component comprising a polymeric relief structure as prepared according to a process as claimed in anyone of claims 1-12.

15. Master for replication purposes In organic or inorganic matter comprising a polymeric relief structure as prepared according to a process as claimed in anyone of claims 1-12.

**Patentansprüche**

1. Photoprägeverfahren zur Herstellung einer polymeren Reliefstruktur, welches die folgenden Schritte umfasst:

(a) Beschichten eines Substrats mit einer Beschichtungszusammensetzung, welche einen oder mehrere strahlungsempfindliche Bestandteile umfasst,
(b) lokales Behandeln des beschichteten Substrats mit einer elektromagnetischen Strahlung, welche ein periodisches oder zufälliges Strahlungsintensitätsmuster aufweist, wodurch ein unsichtbares Bild gebildet wird,
(c) Polymerisieren und/oder Vernetzen des resultierenden beschichteten Substrats,

wobei die Beschichtungszusammensetzung eine Verbindung der Formel I umfasst

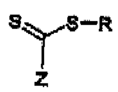

Formel (I)

wobei R für eine substituierte oder unsubstituierte Aryl- oder Alkylgruppe steht und Z für eine organische Gruppe mit 1 bis 100 C-Atomen steht.

**2.** Verfahren nach Anspruch 1, wobei R für eine Einheit der Formel $-C-(R_1)_2Y$ steht, wobei $R_1$ für eine Alkylgruppe steht, die aus der Gruppe ausgewählt ist, die aus Methyl, Ethyl, Propyl, Isopropyl und Butyl besteht, und wobei Y für eine aromatische Gruppe, die aus der Gruppe ausgewählt ist, die aus Phenyl, Tolyl und Naphthyl besteht, oder für eine CN-Gruppe oder eine Ethergruppe oder eine Estergruppe steht.

**3.** Verfahren nach Anspruch 1, wobei R für eine $-C-(CH_3)_2-CN$-Gruppe, eine $-C-(CH_3)_2-Y2$-Gruppe, bei welcher Y2 für eine Phenyl-, Tolyl- oder Naphthylgruppe steht, oder eine $-C-(CH_3)_2-COOR_2$-Gruppe steht, bei welcher $R_2$ für eine $C_{1-10}$-substituierte oder unsubstituierte Alkylgruppe steht.

**4.** Verfahren nach einem der Ansprüche 1 bis 3, wobei R aus der Gruppe ausgewählt ist, die aus $-C-(CH_3)_2-CN$, $-C-(CH_3)_2$-phenyl, $-C-(CH_3)_2$-tolyl und $-C-(CH_3)_2-COOR_3$ besteht, wobei $R_3$ für Methyl, Ethyl, Propyl oder Butyl steht.

**5.** Verfahren nach einem der Ansprüche 1 bis 4, wobei Z aus der Gruppe ausgewählt ist, die aus Phenyl-, Tolyl-, Naphthyl-, Thiol-, Alkylgruppen mit 1 bis 10 Kohlenstoffatomen und Pyrrolgruppen besteht.

**6.** Verfahren nach einem der Ansprüche 1 bis 5, wobei Z für eine aromatische Gruppe mit 6 bis 20 Kohlenstoffatomen steht.

**7.** Verfahren nach einem der Ansprüche 1 bis 6, wobei Z für eine Phenyl- oder Tolylgruppe steht.

**8.** Verfahren nach einem der Ansprüche 1 bis 7, wobei die Beschichtungszusammensetzung ein Gemisch aus mindestens einem Polymer, mindestens einem Monomer, einem Photoinitiator und einer Verbindung der Formel I in einer Menge von 0,1 bis 20 Gew.-% (bezogen auf das Gemisch aus Polymer(en), Monomer(en) und Initiator(en)) umfasst.

**9.** Verfahren nach Anspruch 8, wobei die Menge der Verbindung der Formel I, die Photoinitiatorkonzentration und die Stärke der elektromagnetischen Bestrahlung gemäß der folgenden Formel in Beziehung zueinander stehen:

$$\text{R-Faktor} = \frac{[\text{RAFT}]}{[\text{Initiator}] * \text{Dosis}}$$

wobei [RAFT] für den Gew.-Prozentsatz des Kettenüberträgers der Formel I für den Reversible Addition Fragmentation Chain Transfer steht, [Initiator] für den Gew.-Prozentsatz an Photoinitiator in der Zusammensetzung steht und Dosis für die Bestrahlungsdosis (in $mJ/cm^2$) steht, die während des Aufbaus der Struktur auf die Zusammensetzung angewendet wird, und wobei der R-Faktor im Bereich von 0,0001 bis 0,005 liegt.

**10.** Verfahren nach Anspruch 9, wobei der R-Faktor im Bereich von 0,0005 bis 0,004 liegt.

**11.** Verfahren nach einem der Ansprüche 1 bis 10, wobei die Schritte b) und c) kombiniert werden.

**12.** Verfahren nach einem der Ansprüche 1 bis 11, wobei zwischen den Schritten a) und b) das Lösungsmittel entfernt wird.

**13.** Gegenstand, welcher eine polymere Reliefstruktur umfasst, wie sie über ein Verfahren nach einem der Ansprüche 1 bis 12 hergestellt wird.

**14.** Optische Komponente, welche eine polymere Reliefstruktur umfasst, wie sie über ein Verfahren nach einem der Ansprüche 1 bis 12 hergestellt wird.

**15.** Urform zu Nachbildungszwecken mit organischem oder anorganischem Material, welche eine polymere Reliefstruktur umfasst, wie sie über ein Verfahren nach einem der Ansprüche 1 bis 12 hergestellt wird.

## Revendications

1. Procédé de photo-gaufrage pour la préparation d'une structure polymère en relief comprenant les étapes consistant à :

   a) recouvrir un substrat d'une composition de revêtement comprenant un ou plusieurs ingrédients sensibles aux rayonnements,
   b) traiter localement le substrat recouvert avec des rayonnements électromagnétiques ayant une répartition d'intensité des rayonnements périodique ou aléatoire, en formant une image latente,
   c) polymériser et/ou réticuler le substrat recouvert obtenu, dans laquelle la composition de revêtement comprend un composé selon la formule I

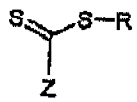

Formule (I)

   dans laquelle R = groupes aryle ou alkyle substitués ou non substitués ; Z = groupe organique ayant de 1 à 100 atomes C.

2. Procédé selon la revendication 1, dans lequel R est un composé de formule $-C-(R_1)_2-Y$, où $R_1$ est un groupe alkyle choisi dans le groupe constitué par le méthyle, l'éthyle, le propyle, l'isopropyle et le butye, et où Y est un groupe aromatique choisi dans le groupe constitué par le phényle, le tolyle et le naphtyle ; ou un groupe CN ; ou un groupe éther ; ou un groupe ester.

3. Procédé selon la revendication 1, dans lequel R est un groupe $-C-(CH_3)_2-CN$, $-C-(CH_3)_2-Y2$, où Y2 est un groupe phényle, tolyle ou naphtyle, ou un groupe $-C-(CH_3)_2-COOR_2$, où $R_2$ est un groupe alkyle en $C_1$ à $C_{10}$ substitué ou non substitué.

4. Procédé selon l'une quelconque des revendications 1 à 3, dans lequel R est choisi dans le groupe constitué par $-C-(CH_3)_2-CN$, $-C-(CH_3)_2$-phényle, $-C-(CH_3)_2$-tolyle et $-C-(CH_3)_2-COOR_3$, où $R_3$ est du méthyle, de l'éthyle, du propyle ou du butyle.

5. Procédé selon l'une quelconque des revendications 1 à 4, dans lequel Z est choisi dans le groupe constitué par le phényle, le tolyle, le naphtyle, le thiol, l'alkyle ayant de 1 à 10 atomes de carbone, et des groupes pyrrole.

6. Procédé selon l'une quelconque des revendications 1 à 5, dans lequel Z est un groupe aromatique ayant de 6 à 20 atomes de carbone.

7. Procédé selon l'une quelconque des revendications 1 à 6, dans lequel Z est un groupe phényle ou tolyle.

8. Procédé selon l'une quelconque des revendications 1 à 7, dans lequel la composition de revêtement comprend un mélange d'au moins un polymère, d'au moins un monomère, d'un photo-initiateur et d'un composé selon la formule I dans une quantité comprise entre 0,1 et 20 % en masse (par rapport au mélange de polymère(s), monomère(s) et initiateur(s)).

9. Procédé selon la revendication 8, dans lequel la quantité de composé selon la formule I, la concentration en photo-initiateur et la quantité d'irradiation électromagnétique sont liées les unes aux autres selon la formule :

$$\text{Facteur F} = \frac{[\text{RAFT}]}{[\text{initiateur}] * \text{Dose}}$$

   où [RAFT] est le % en masse d'agent de transfert de chaînes en polymérisation réversible d'addition fragmentation selon la formule I, [initiateur] est le % en masse de photo-initiateur dans la composition, et Dose est la dose de rayonnement appliquée à la composition pendant la construction de la structure (en $mJ.cm^{-2}$) et où le facteur F est

compris entre 0,0001 et 0,005.

**10.** Procédé selon la revendication 9, dans lequel le facteur R est compris entre 0,0005 et 0,004.

**11.** Procédé selon l'une quelconque des revendications 1 à 10, dans lequel les étapes b) et c) sont combinées.

**12.** Procédé selon l'une quelconque des revendications 1 à 11, dans lequel le solvant est éliminé entre les étapes a) et b).

**13.** Article comprenant une structure polymère en relief telle que préparée selon un procédé tel que revendiqué dans l'une quelconque des revendications 1 à 12.

**14.** Composant optique comprenant une structure polymère en relief telle que préparée selon un procédé tel que revendiqué dans l'une quelconque des revendications 1 à 12.

**15.** Gabarit pour réplication dans une matière organique ou inorganique comprenant une structure polymère en relief telle que préparée selon un procédé tel que revendiqué dans l'une quelconque des revendications 1 à 12.

**Figure 1.** RAFT agent to initiator ratio for the maximum structure height (20 µm pitch) as function of dose.

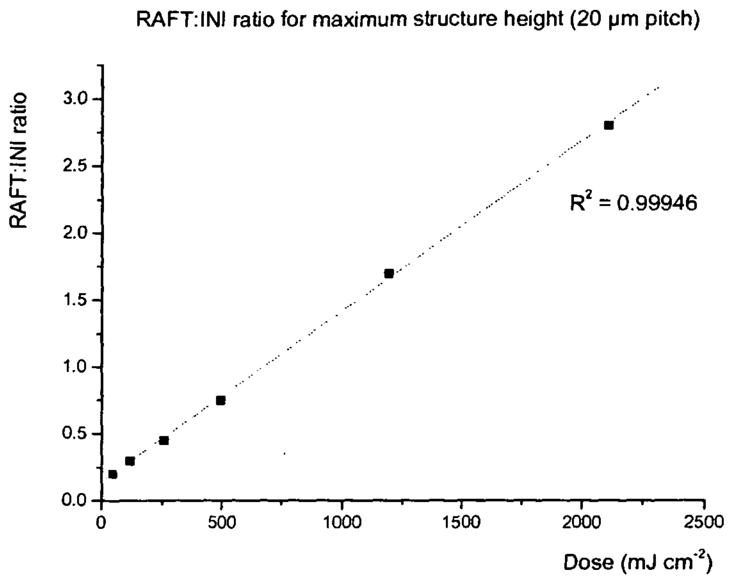

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2005081071 A
- WO 2006085741 A
- WO 2005008321 A
- US 2005032997 A
- WO 9931144 A
- WO 0018696 A


### Non-patent literature cited in the description


- **De Witz, Christiane ; Broer, Dirk J.** photo-embossing is known from ''photo-embossing as a tool for complex surface relief structures. *Abstracts of Papers, 226th ACS National Meeting,* 07 September 2003
- *Polymer International,* 2000, vol. 49, 993-1001